**Europäisches Patentamt**

**European Patent Office**

**Office européen des brevets**

(19)

(11) Veröffentlichungsnummer: **0 226 201 B1**

# EUROPÄISCHE PATENTSCHRIFT

(12)

(45) Veröffentlichungstag der Patentschrift: **27.01.93**

(51) Int. Cl.⁵: **G03F 7/021**

(21) Anmeldenummer: **86117428.2**

(22) Anmeldetag: **15.12.86**

---

(54) **Lichtempfindliche Druckplatte für den wasserlosen Offsetdruck.**

---

(30) Priorität: **20.12.85 DE 3545204**

(43) Veröffentlichungstag der Anmeldung:
**24.06.87 Patentblatt 87/26**

(45) Bekanntmachung des Hinweises auf die
Patenterteilung:
**27.01.93 Patentblatt 93/04**

(84) Benannte Vertragsstaaten:
**CH DE FR GB LI**

(56) Entgegenhaltungen:
**US-A- 3 677 178**
**US-A- 3 867 147**

(73) Patentinhaber: **HOECHST AKTIENGESELL-
SCHAFT**
**Postfach 80 03 20**
**W-6230 Frankfurt am Main 80(DE)**

(72) Erfinder: **Schlosser, Hans-Joachim, Dr.**
**Am Rosengarten 2a**
**W-6200 Wiesbaden(DE)**

---

EP 0 226 201 B1

**Beschreibung**

Die Erfindung betrifft eine lichtempfindliche Druckplatte mit einem Schichtträger, einer lichtempfindlichen Schicht und einer darüberliegenden, Druckfarbe abstoßenden Schicht aus einem Silikonkautschuk.

Druckplatten der genannten Art sind z. B. aus der DE-A 16 71 637 bekannt. Als lichtempfindliche Schichten werden darin bevorzugt solche auf Basis von Polykondensationsprodukten aus aromatischen Diazoniumsalzen und Formaldehyd eingesetzt. Diese Schichten werden durch Belichten im Entwickler unlöslich und können mit wäßrigen Lösungen entwickelt werden. Bei der Entwicklung werden die Bereiche der Silikonkautschukschicht, die über den löslichen, ungehärteten Bereichen der lichtempfindlichen Schicht liegen, zusammen mit diesen löslichen Bereichen entfernt, obwohl sie im Entwickler unlöslich sind. Allerdings ist es erforderlich, dem Entwickler organische Lösungsmittel in ausreichendem Maße zuzusetzen, daß der Silikonkautschuk darin gequollen und dadurch erweicht wird. Zur Entwicklung werden z. B. Gemische von Isopropanol und Wasser verwendet.

Als Silikonkautschuke werden hierfür Einkomponentenkautschuke eingesetzt, die zum Aushärten nach dem Aufbringen der Schicht Feuchtigkeit benötigen und längere Zeit erfordern. Solche Einkomponenten-Silikonkautschuke sind gewöhnlich Polysiloxane, z. B. Dimethylpolysiloxane, die endständige Acetyl-, Oxim-, Hydroxy- oder Aminogruppen enthalten.

In der DE-A 23 23 972 ist eine ähnliche Platte mit einem Einkomponenten-Silikonkautschuk beschrieben, deren lichtempfindliche Schicht ein Reaktionsprodukt aus einem Diphenylamin-4-diazoniumsalz-Formaldehyd-Kondensationsprodukt und der 2-Hydroxy-4-methoxy-benzophenon-5-sulfonsäure und gegebenenfalls ein Bindemittel enthält. Da das Diazoniumsalz-Fällungsprodukt sehr schwerlöslich ist, wird sowohl die Herstellung als auch die Entwicklung der Platte erheblich erschwert.

In der DE-A 23 57 871 sind auch vorsensibilisierte Druckplatten für den wasserlosen Offsetdruck beschrieben, die eine Mehrkomponenten-Silikonkautschukschicht enthalten. Diese Schichten enthalten neben Organopolysiloxanen z. B. niedermolekulare Silane, die mit funktionellen Endgruppen der Polysiloxane unter Vernetzung in Abwesenheit von Feuchtigkeit zu reagieren vermögen. Diese Mehrkomponentensysteme können durch Additions- oder Kondensationsreaktionen vernetzen. Beim Additionstyp reagieren z. B. endständige Alkenylgruppen mit Si-H-Gruppen in Gegenwart von Katalysatoren bei erhöhter Temperatur. Bei den kondensationsvernetzenden Systemen reagieren endständige funktionelle Gruppen von Polydiorganosiloxanen mit funktionellen Gruppen von Silanen oder Oligosiloxanen, die als Vernetzer wirken, zumeist in Gegenwart von Katalysatoren.

Die mit diesen Silikonkautschukschichten erhaltenen Druckplatten zeigen eine gute Farbabweisung an den Nichtbildstellen und eine gute Resistenz der farbabweisenden Silikonschicht.

Mit den als lichtempfindliche Schichten bevorzugten Diazoniumsalzschichten lassen sich die besten Bildauflösungen erzielen. Allerdings lassen sich diese zumeist stark hydrophilen Schichten gerade mit den bevorzugten besonders farbabweisenden und resistenten Silikonschichten nur schwierig kombinieren. Häufig ist dann keine Lösungsmittelkombination zu finden, die zugleich die Nichtbildstellen der Diazoschicht auflöst, ohne die Bildstellen anzugreifen, und die Silikonkautschukschicht an den Nichtbildstellen vollständig und sauber entfernt.

Aufgabe der Erfindung war es, eine für den wasserlosen Offsetdruck geeignete vorsensibilisierte Druckplatte vorzuschlagen, die es ermöglicht, hohe Druckauflagen bei guter Farbabweisung der Nichtbildstellen und zugleich eine saubere Entwicklung mit hoher Bildauflösung zu erreichen. Die Druckplatte sollte leicht herstellbar sein und eine hohe Lichtempfindlichkeit aufweisen.

Erfindungsgemäß wird eine lichtempfindliche Druckplatte für den wasserlosen Offsetdruck aus einem Schichtträger, einer lichtempfindlichen, ein Diazoniumsalz-Polykondensationsprodukt enthaltenden Schicht und einer darüberliegenden, Druckfarbe abstoßenden vernetzten Silikonkautschukschicht vorgeschlagen.

Die erfindungsgemäße Druckplatte ist dadurch gekennzeichnet, daß das Diazoniumsalz-Polykondensationsprodukt aus wiederkehrenden Einheiten $A-N_2X$ und $B$ besteht, die durch Zwischenglieder, vorzugsweise Methylengruppen, miteinander verbunden sind, die von kondensationsfähigen Carbonylverbindungen abgeleitet sind, wobei $A$ der Rest einer mit Formaldehyd kondensationsfähigen aromatischen Diazoniumverbindung und $B$ der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

Als Diazoniumsalz-Polykondensationsprodukte werden insbesondere solche Produkte bevorzugt, in denen die Einheiten $A-N_2X$ von Verbindungen der allgemeinen Formel

$$(R^1-R^3-)_pR^2-N_2X$$

2

EP 0 226 201 B1

abgeleitet sind, wobei

X        das Anion der Diazoniumverbindung,

p        eine ganze Zahl von 1 bis 3,

$R^1$       einen aromatischen Rest mit mindestens einer zur Kondensation mit aktiver Carbonylverbindung befähigten Position,

$R^2$       eine ggf. substituierte Phenylengruppe,

$R^3$       eine Einfachbindung oder eine der Gruppen:

$-(CH_2)_q-NR^4-$,

$-O-(CH_2)_r-NR^4-$,

$-S-(CH_2)_r-NR^4-$,

$-S-CH_2CO-NR^4-$,

$-O-R^5-O-$,

$- O -$

$- S -$ oder

$-CO-NR^4-$

bedeuten, worin

q        eine Zahl von 0 bis 5,

r        eine Zahl von 2 bis 5,

$R^4$       Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

$R^5$       eine Arylengruppe mit 6 bis 12 C-Atomen ist.

Die vorstehend definierten Diazoniumsalz-Polykondensationsprodukte sind bekannt und in den US-A 3 867 147 und 3 849 392 beschrieben. Weitere geeignete Kondensationsprodukte dieses Typs sind in der EP-A 126 875 beschrieben.

Die lichtempfindliche Schicht kann im wesentlichen allein aus dem Diazoniumsalz-Kondensationsprodukt bestehen. Sie enthält vorzugsweise noch ein polymeres Bindemittel. Als Bindemittel kommen vorzugsweise wasserunlösliche Polymere, wie Epoxyharze, Harnstoff und Melaminharze, Ketonharze, Vinylacetalhomo- und copolymere, Polyvinylacetale, z. B. Polyvinylformale oder Polyvinylbutyrale; Polyurethane, Polyacrylate, Polymethacrylate und Celluloseester in Betracht. Von den genannten Polymeren werden die Polyvinylacetale, insbesondere solche, die noch freie Vinylalkohol- und Vinylestereinheiten enthalten, bevorzugt.

Es können auch Bindemittel verwendet werden, die in Wasser unlöslich, aber in wäßrig-alkalischen Lösungen löslich sind. Derartige Bindemittel sind Phenolharze, Polyvinylphenole, Polysulfonylurethane, Acryl- und Methacrylsäurecopolymere, Styrol/Maleinsäureanhydrid-Copolymere und Umsetzungsprodukte von OH-Gruppen enthaltenden Polymeren, insbesondere Vinylalkoholeinheiten enthaltenden Polymeren, mit Anhydriden mehrwertiger Carbonsäuren, insbesondere von Di- oder Tricarbonsäuren. Die zuletzt genannten Polymeren werden besonders bevorzugt. Sie sind in der EP-A 152 819 beschrieben.

Beispiele für geeignete Säureanhydride sind:

Maleinsäureanhydrid und Derivate, z.B. Dimethylmaleinsäureanhydrid oder Citraconsäureanhydrid,

Bernsteinsäureanhydrid und Derivate, z.B. Methylbernsteinsäureanhydrid,

Glutarsäureanhydrid und Derivate, 3-Oxa-glutarsäureanhydrid und Derivate, Phthalsäureanhydrid und Substitutionsprodukte, teilweise oder vollständig hydrierte Phthalsäureanhydride, z.B. Hexahydrophthalsäureanhydrid oder Cyclohexen-1,2-dicarbonsäureanhydrid,

Naphthalin-2,3-dicarbonsäureanhydrid oder Naphthalin-1,8-dicarbonsäureanhydrid und deren Substitutionsprodukte,

di- oder polycyclische Anhydride, die durch Diels-Alder-Reaktion eines Diens mit Maleinsäureanhydrid entstehen, z.B. die Additionsprodukte aus Furan, Anthracen, Cyclohexadien-1,3 oder Cyclopentadien und Maleinsäureanhydrid.

Bevorzugt werden die Reaktionsprodukte mit Malein-, Phthal-, Bernstein- und 3-Oxa-glutarsäureanhydrid.

Als Hydroxygruppen enthaltende synthetische Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht.

Als Polymere mit Vinylalkoholeinheiten sind teilverseifte Polyvinylester, Polyvinylacetale mit freien

3

Hydroxygruppen sowie entsprechende Umsetzungsprodukte von Copolymeren bzw. Copolymerisaten mit Vinylester- oder Vinylacetal- oder Vinylalkoholeinheiten geeignet.

Die lichtempfindlichen Schichten enthalten im allgemeinen 5 bis 90, bevorzugt 10 bis 70 Gew.-% Diazoniumverbindung und 95 bis 10, bevorzugt 90 bis 30 Gew.-% polymeres Bindemittel.

Zur Stabilisierung der lichtempfindlichen Schicht ist es vorteilhaft, dieser eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Die lichtempfindlichen Gemische können ferner Farbstoffe und/oder Pigmente enthalten, die als Kontrastmittel wirken können. In Frage kommende Farbstoffe sind beispielsweise in den US-A 3 218 167 und 3 884 693 angegeben. Besonders geeignet sind z. B. Viktoriareinblau FGA, Renolblau B2G-H (C.I. 74160), Kristallviolett oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Die Schichtdicke der lichtempfindlichen Schicht beträgt im allgemeinen 0,2 bis 3, bevorzugt 0,5 bis 1,5 μm.

Auf die lichtempfindliche Schicht wird dann die Silikonkautschukschicht aufgebracht. Sie wird aus einer Lösung in einem unpolaren Lösungsmittel, z. B. aliphatischen oder aromatischen Kohlenwasserstoffen, aufgebracht, in dem sich die Bestandteile der lichtempfindlichen Schicht unter den Beschichtungsbedingungen praktisch nicht auflösen.

Grundsätzlich ist jeder Silikonkautschuk geeignet, der ausreichend farbabweisend ist, um ein Drucken im Offsetdruck ohne Feuchtwasser zu erlauben. Als "Silikonkautschuk" soll im Rahmen dieser Erfindung entsprechend der Definition von Noll, "Chemie und Technologie der Silikone", Verlag Chemie, 1968, S. 332, ein hochmolekulares, im wesentlichen lineares Diorganopolysiloxan bezeichnet werden, während für die vernetzten bzw. vulkanisierten Produkte die Bezeichnung "Silikongummi" verwendet wird. In jedem Fall wird eine Silikonkautschuklösung auf die lichtempfindliche Schicht aufgebracht, getrocknet und dann vernetzt.

Als Silikonkautschuke sind Einkomponenten- und Mehrkomponententypen geeignet, wie sie z. B. in den DE-A 23 50 211, 23 57 871 und 23 59 102 beschrieben sind.

Die Einkomponenten-Silikonkautschuke basieren auf Polysiloxanen, die z. B. endständige Acetyl-, Oxim-, Alkoxy- oder Aminogruppen oder Wasserstoffatome enthalten. Im übrigen besteht das Polysiloxan im wesentlichen aus einer Dimethylpolysiloxankette. Die Methylgruppen können in geringerem Umfang auch durch andere Alkylgruppen, durch Halogenalkylgruppen oder substituierte oder unsubstituierte Arylgruppen ersetzt sein. Die endständigen funktionellen Gruppen sind leicht hydrolysierbar und härten bei Feuchtigkeitseinwirkung innerhalb von einigen Minuten bis Stunden aus.

Die Mehrkomponenten-Silikonkautschuke können durch Addition oder durch Kondensation vernetzbar sein. Die additionsvernetzbaren Typen enthalten im allgemeinen Polysiloxane mit Alkenylgruppen als Substituenten und solche mit an Silicium gebundenen Wasserstoffatomen. Sie werden in Gegenwart von Platinkatalysatoren bei Temperaturen oberhalb 50° C vernetzt. Sie haben den Vorteil, daß sie bei höherer Temperatur, z. B. um 100° C, schnell vernetzen. Dafür kann auch die Verarbeitungsdauer (Topfzeit) dieser Systeme relativ kurz sein.

Die durch Kondensation vernetzbaren Gemische enthalten Diorganopolysiloxane mit reaktionsfähigen Endgruppen, z. B. OH- und Acetoxygruppen. Diese werden mit reaktiven Silanen oder Oligosiloxanen in Gegenwart von Katalysatoren vernetzt. Auch diese Kombinationen reagieren relativ schnell und haben deshalb eine begrenzte Topfzeit.

Mit besonderem Vorteil werden durch Addition oder Kondensation vernetzbare Mehrkomponenten-Silikonkautschuke eingesetzt, wie sie in der DE-C 21 19 120 und DE-A 26 54 893 beschrieben sind.

Diese bevorzugten Silikonkautschuke sind einmal durch Kondensation vernetzbare Kombinationen aus a) Diorganopolysiloxanen mit endständigen Si-OH-Gruppen; b) Organopolysiloxanen, die an Silicium gebundene Wasserstoffatome, aber keine Aminogruppen enthalten; c) aminosubstituierten Organosiliciumverbindungen und d) katalytisch wirkenden Organozinnverbindungen. Ferner gehören dazu durch Addition vernetzbare Mehrkomponenten-Silikonkautschuke aus a) Diorganopolysiloxanen mit endständigen Si-Vinylgruppen; b) Organopolysiloxanen mit mindestens drei an Silicium gebundenen Wasserstoffatomen; c) Platinkomplexen von Vinylsiloxanen und d) einem Mittel, das die Anlagerung von an Silicium gebundenen Wasserstoffatomen an aliphatische Mehrfachbindungen bei Raumtemperatur verzögert.

Die Silikonkautschuke werden nach dem Aufbringen als Schicht in bekannter Weise durch Feuchtigkeitseinwirkung oder aus sich heraus bei Raumtemperatur oder erhöhter Temperatur zu einem in organischen Lösungsmittel im wesentlichen unlöslichen Silikongummi vernetzt. Die fertige Silikongummischicht hat im allgemeinen eine Dicke von 1 bis 20, bevorzugt von 2 bis 10 μm. Wie bereits erwähnt, erfolgt die Beschichtung im allgemeinen aus unpolaren Lösungsmitteln, z. B. Paraffinkohlenwasserstoffen, die die darunterliegende lichtempfindliche Schicht wenig oder gar nicht lösen.

Die bevorzugten Mehrkomponenten-Silikonkautschuke haben den Vorteil, daß damit hergestellte Druckplatten beim Drucken ohne Feuchtwasser eine wesentlich geringere Neigung zum Tonen aufweisen als solche, die mit normalen Einkomponenten-Silikonkautschuken hergestellt worden sind. Auch die Kratzfestigkeit der Oberfläche des gehärteten Silikongummis ist bei den bevorzugten Verbindungstypen erhöht.

Durch die Verwendung der oben beschriebenen Diazoniumsalz-Mischkondensationsprodukte wird der Einsatz der vorstehend genannten besonders vorteilhaften Silikonkautschuke ermöglicht. Schichtkombinationen aus den genannten Diazoniumsalz-Kondensationsprodukten und den bevorzugten besonders resistenten und farbabweisenden Mehrkomponenten-Silikonkautschuken lassen sich leicht und sauber mit organischen Lösungsmitteln, ggf. auch unter Zusatz von Wasser, entwickeln. Da sich die erfindungsgemäß eingesetzten Diazoniumsalz-Kondensationsprodukte ohne Schwierigkeiten mit den verschiedensten organischen Polymeren als Bindemittel kombinieren lassen, ist es möglich, gut haftende Kombinationen auch mit solchen Silikongummischichten zu erhalten, die sich mit den bisher gebräuchlichen Kondensationsprodukten aus Diazoniumsalzen nicht oder nur begrenzt kombinieren ließen. Dabei ist es besonders vorteilhaft, solche Diazoniumsalz-Mischkondensationsprodukte einzusetzen, die sich in organischen Lösungsmitteln lösen, in Wasser aber praktisch nicht löslich sind. Dies erreicht man in bekannter Weise durch Wahl des geeigneten Anions des Diazoniumsalzes.

Die erfindungsgemäßen Druckplatten lassen sich auch mit Vorteil mit Einkomponenten-Silikonkautschuken herstellen. Auch bei diesen Kombinationen wird eine bessere Haftung der Schichten aneinander und eine bessere Entwickelbarkeit erreicht als mit den bisher bekannten und üblichen Diazoniumsalz-Kondensaten. Die großen Vorteile werden jedoch, wie oben erwähnt, mit den bevorzugten Mehrkomponenten-Silikonkautschuken erzielt.

Als Schichtträger werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann. Weitere geeignete Metalle sind Stahl und Chrom. Da es, im Gegensatz zu üblichen Flachdruckplatten, nicht erforderlich ist, daß die Trägeroberfläche hydrophil ist, können mit Vorteil auch Kupfer, Messing oder andere oleophile Metalle als Trägeroberfläche dienen. Ebenso können Kunststoffolien, wie Polyester-, Polycarbonat-, Polyimid- oder auch Celluloseacetatfolien verwendet werden, deren Oberfläche ggf. zur Erhöhung der Benetzbarkeit durch Druckfarbe vorbehandelt sein kann. Auch gummielastische Trägermaterialien sind geeignet; mit solchen Trägern kann auch im direkten Flachdruck gedruckt werden.

Das Trägermaterial dient bei den Druckformen, die aus dem erfindungsgemäßen Material hergestellt werden, im Gegensatz zu sonst üblichen Druckformen, als farbführendes Material. Die nach dem Belichten und Entwickeln stehengebliebene Silikongummischicht dient als Bildhintergrund und wirkt in trockenem Zustand farbabstoßend. Zum Druck können dabei sowohl übliche Druckfarben auf Ölbasis als auch spezielle hydrophile Druckfarben dienen, wie sie für den wasserlosen Offsetdruck sowie für den umgekehrten Offsetdruck entwickelt wurden und im Handel erhältlich sind. Da die meisten gebräuchlichen Schichtträgeroberflächen, z. B. aufgerauhtes oder anodisch oxydiertes Aluminium, stark hydrophil sind, werden hydrophile Druckfarben mit Vorteil eingesetzt.

Zur Entwicklung der belichteten Druckplatten werden bevorzugt Gemische von organischen Lösungsmitteln untereinander oder mit Wasser verwendet. Dabei wird ein Bestandteil gewählt, der die Silikongummischicht zu quellen vermag, und ein Bestandteil, der die Diazoniumsalzschicht nach dem Belichten selektiv auflöst. In den meisten Fällen werden die unbelichteten Schichtbereiche gelöst, während die belichteten zurückbleiben. Bei bestimmten Kombinationen von Kondensationsprodukten, Bindemitteln und Entwicklern ist es aber auch möglich, die belichteten Schichtbereiche selektiv aufzulösen, d. h. eine negativ arbeitende Druckplatte zu erhalten. Beispiele für geeignete Entwickler sind Kombinationen von Paraffinkohlenwasserstoffen mit polaren Lösemitteln, wie Estern, Ketonen oder Alkoholen. Geeignet sind auch Kombinationen von mit Wasser mischbaren Lösungsmitteln, wie niederen Alkoholen oder Ketonen, und Wasser.

Im folgenden werden Beispiele für bevorzugte Ausführungsformen der Erfindung beschrieben. Wenn nichts anderes angegeben ist, sind Mengenverhältnisse und Prozentangaben auf das Gewicht bezogen. Vor den Ausführungsbeispielen werden die verwendeten Silikonkautschuklösungen und Diazoniumsalz-Kondensationsprodukte angegeben.

Verwendete Silikonkautschuklösungen

A) Eine handelsübliche 60 %ige Lösung eines bei Raumtemperatur vernetzenden Silikonkautschuks in Toluol (Viskosität ca. 350 mPa.s bei 23° C) wurde im Verhältnis 1:4 mit einem Isoparaffingemisch mit dem Siedebereich 116-136° C bei Normaldruck (Isopar E) verdünnt.

B) Eine Lösung von 5 Gewichtsteilen eines Dimethylpolysiloxans mit endständigen, an Silicium gebundenen OH-Gruppen, das eine Plastizität nach Brabender von 5,8 kNm aufweist, und 0,3 Gewichtsteilen einer Lösung eines Methylhydrogenpolysiloxans mit endständigen Trimethylsiloxygruppen mit einer Viskosität von 0,4 cm$^2$/s bei 25° C in 9,7 Gewichtsteilen Toluol wird mit 84 Gewichtsteilen einer 50 %igen Lösung des Umsetzungsprodukts aus 1,99 Gewichtsteilen eines Dimethylpolysiloxans mit endständigen OH-Gruppen (OH-Gruppengehalt 3,5 %) und 1 Gewichtsteil 3-(2-Amino-ethylamino)-propyltrimethoxysilan versetzt. Dann werden 0,3 Gewichtsteile Dibutylzinndiacetat zugegeben, und das Ganze wird vermischt. Die Mischung läßt sich bis zu 24 Stunden verarbeiten.

C) Der Lösung B werden 0,4 Gewichtsteile eines Gemischs aus Vinyltrimethoxysilan und 3-Glycidyloxypropyltrimethoxysilan zugesetzt und damit vermischt.

D) 10 Gewichtsteile eines Dimethylpolysiloxans mit endständigen Vinyldimethylsiloxaneinheiten mit einer Viskosität von 400 mPa.s bei 25° C wurden mit 0,025 Gewichtsteilen 2-Methyl-3-butin-2-ol, 0,03 Gewichtsteilen der unten beschriebenen Mischung aus Platinkomplex von Vinylsiloxan und Verdünnungsmittel, 0,09 Gewichtsteilen eines Mischpolymerisats aus 4 mol-% Trimethylsiloxan-, 72 mol-% Methylhydrogensiloxan- und 24 mol-% Dimethylsiloxaneinheiten mit einer Viskosität von 50 mPa.s bei 25° C und einem Gehalt von 1,36 % an Si gebundenen Wasserstoffs und 88,9 Gewichtsteilen Isopar E vermischt. Die Mischung läßt sich bis zu 24 Stunden nach der Herstellung verarbeiten.

Die Platinkomplex-Mischung wurde wie folgt hergestellt: Zu einer Mischung aus 10 Gewichtsteilen $H_2PtCl_6 x6H_2O$, 20 Gewichtsteilen 1,3-Divinyl-1,1,3,3-tetramethyldisiloxan und 50 Gewichtsteilen Ethanol wurden 20 Gewichtsteile Natriumhydrogencarbonat gegeben. Das Gemisch wurde 30 Minuten unter Rühren zum Sieden unter Rückfluß erhitzt, dann 15 Stunden stehen gelassen und danach filtriert. Aus dem Filtrat wurden bei 16 mbar die flüchtigen Bestandteile abdestilliert. Als Rückstand wurden 17 Gewichtsteile einer Flüssigkeit erhalten, die in Benzol gelöst wurde. Die Lösung wurde filtriert und aus dem Filtrat das Benzol abdestilliert. Der Rückstand wurde mit einem Dimethylpolysiloxan, das endständige Vinyldimethylsiloxaneinheiten hatte und eine Viskosität von 1,4 Pa.s bei 23° C aufwies, als Verdünnungsmittel in solcher Menge vermischt, daß das Gemisch 1 Gew.-% Platin, berechnet als Element, enthielt.

Verwendete Diazoniumsalz-Kondensationsprodukte

1.) Kondensationsprodukt aus Diphenylamin-4-diazoniumsalz und Formaldehyd, isoliert als Tetrachlorozinkat (Vergleich)

2.) Kondensationsprodukt aus Diphenylamin-4-diazoniumsalz und Formaldehyd, ausgefällt mit 2-Hydroxy-4-methoxy-benzophenon-5-sulfonsäure (Vergleich)

3.) Kondensationsprodukt aus 1 mol 3-Methoxy-diphenylamin-4-diazoniumsalz und 1 mol 4,4′-Bismethoxymethyl-diphenylether, isoliert als Mesitylensulfonat

4.) Kondensationsprodukt aus 1 mol 3-Methoxy-diphenylamin-4-diazoniumsalz, 1 mol 4-Methyl-4′-methoxymethyl-diphenylether und 1 mol 4,4′-Bis-methoxymethyl-diphenylether, ausgefällt als Mesitylensulfonat.

Beispiel 1 (Vergleichsbeispiel)

Auf eine elektrolytisch aufgerauhte und anodisch oxydierte Aluminiumplatte wurde eine 5 %ige wäßrige Lösung des Diazoniumsalz-Kondensationsprodukts 1 aufgebracht. Nach dem Trocknen betrug das Schichtgewicht 1 g/m$^2$.

Auf diese Platte wurden verschiedene Deckschichten aus Silikonkautschuk aufgebracht:

a) Lösung A wurde aufgebracht und 10 Minuten bei 100° C getrocknet. Die getrocknete Silikonkautschukschicht hatte ein Schichtgewicht von 3,5 g/m$^2$. Die Platte wurde nach 24 Stunden Lagern 60 s mit einer Metallhalogenidlampe (5 kW) unter einer Vorlage belichtet. Die Platte wurde einmal mit Isopropanol/Wasser (2:1), in einem zweiten Versuch mit einem Gemisch von Isoparaffinen mit dem Siedebereich 176-188° C (Isopar H) und Aceton (1:1) entwickelt.

b) Es wurde die Lösung B aufgebracht und 1 Minute bei 100° C getrocknet. Die weitere Behandlung erfolgte wie unter a).

c) Es wurde mit Lösung D beschichtet; die weitere Behandlung erfolgte wie unter b).

Beispiel 2 (Vergleich)

Eine Beschichtung mit dem Diazoniumsalz-Kondensationsprodukt 2 ließ sich nicht durchführen, weil es in keinem der Lösungsmittel Wasser, Aceton, Dimethylsulfoxid und 2-Methoxy-ethanol und auch nicht in einem Gemisch von Tetrahydrofuran, Dimethylformamid und Methanol ausreichend löslich war.

Beispiel 3

Die im Beispiel 1 angegebene Aluminiumplatte wurde mit einer 5 %igen Lösung des Diazoniumsalz-Kondensationsprodukts 3 in 2-Methoxyethanol beschichtet. Das Schichtgewicht betrug nach dem Trocknen 1 g/m$^2$. Die erhaltenen Platten wurde wie bei 1a bis 1c mit Deckschichten versehen und dann wie in Beispiel 1 belichtet. Alle Platten wurden mit einem Gemisch aus Isopar H und Aceton (1:1) entwickelt.

Die folgende Tabelle zeigt die Entwickelbarkeit der Schichten der Beispiele 1 und 3:

| | Beispiel 1 | | Beispiel 3 |
|---|---|---|---|
| | Isopropanol/Wasser | Isopar H/Aceton | Isopar H/Aceton |
| a | ausreichend entwickelt | gut entwickelt | gut entwickelt |
| b | nicht entwickelt | nicht entwickelt | gut entwickelt |
| c | Schicht nicht fest | | gut entwickelt |

Beispiel 4

3 Gewichtsteile des Diazoniumsalz-Kondensationsprodukts 3 und 3 Gewichtsteile eines Polyvinylbutyrals mit einem Molekulargewicht von 70000 bis 80000, das 71 % Vinylbutyral-, 2 % Vinylacetat- und 27 % Vinylalkoholeinheiten enthält, wurden in 93,68 Gewichtsteilen 2-Methoxy-ethanol gelöst. Zu der Lösung wurden 0,3 Gewichtsteile Phthalocyanin und 0,02 Gewichtsteile Phenylazodiphenylamin gegeben. Die Lösung wurde auf den in Beispiel 1 angegebenen Träger aufgebracht und getrocknet. Das Schichtgewicht betrug 1 g/m$^2$. Auf verschiedene Proben der Platte wurden Deckschichten aus den Silikonkautschuken A, B und D aufgebracht. Nach 25 s Belichtung wie in Beispiel 1 und Entwicklung mit Isopar H/Aceton 1:1 wurden Druckformen guter Auflösung erhalten.

Gedruckt wurde einmal mit handelsüblicher Druckfarbe auf Ölbasis, wobei Drucke guter Qualität erhalten wurden. Ähnlich gute Ergebnisse wurden auch mit einer hydrophilen Druckfarbe erhalten, die wie folgt hergestellt worden war:

40 Gew.-Teile einer wäßrigen Emulsion eines alkalilöslichen Acrylatpolymerisats mit einem Festkörpergehalt von 40 Gew.-%, 20 Gew.-Teile Propylenglykol, 4 Gew.-Teile Triethanolamin, 4 Gew.-Teile einer 35 %igen Methylsilikonölemulsion, 4 Gew.-Teile Mineralöl mit einem Siedebereich von 190 - 250° C und 8 Gew.-Teile Stärkeether wurden miteinander gemischt. Dieser Mischung wurden 20 Gew.-Teile eines wäßrigen Pigmentteiges mit einem Gehalt von 45 Gew.-% Kupferphthalocyaninpigment zugefügt. Die Masse wurde auf einer Dreiwalze zu einer homogenen Druckfarbe dispergiert.

Beispiel 5

Beispiel 4 wurde wiederholt mit der Abweichung, daß anstelle des Polyvinylbutyrals die gleiche Menge des Umsetzungsprodukts von 50 Gewichtsteilen dieses Polyvinylbutyrals mit 4 Gewichtsteilen Maleinsäureanhydrid eingesetzt wurde. Außerdem wurden der Beschichtungslösung 0,18 Gewichtsteile 85 %iger Phosphorsäure zugesetzt. Nach dem Entwickeln wie in Beispiel 4 wurden Druckformen mit sehr guter Auflösung erhalten. Die Druckauflagen waren wie folgt:

7

| a | mehr als 10.000 |
|---|---|
| b | mehr als 50.000 |
| c | mehr als 15.000 |

Beispiel 6

Beispiel 5 wurde wiederholt mit der Abweichung, daß anstelle des dort verwendeten Diazoniumsalz-Polykondensationsprodukts das Produkt 4 in gleicher Menge eingesetzt wurde. Mit den Deckschichten B und D wurden Druckformen mit guter Auflösung erhalten.

Beispiel 7

Beispiel 5 wurde wiederholt mit der Abweichung, daß als Schichtträger eine Polyethylenterephthalatfolie verwendet wurde, die mit einer Dispersion von Polyvinylidenchlorid in wäßriger Trichloressigsäure zur Haftvermittlung vorbehandelt worden war. Auch hier wurden Druckformen mit guter Auflösung erhalten.

Beispiel 8

Eine Platte aus walzblankem Aluminium wurde mit einer 2 %igen Lösung von 3-(2-Amino-ethylamino)-propyltrimethoxysilan in Isopar E vorbehandelt. Sie wurde dann mit der in Beispiel 4 angegebenen lichtempfindlichen Beschichtungslösung beschichtet. Dann wurde eine Deckschicht aus Lösung C aufgebracht. Die Platte wurde bildmäßig belichtet und mit einem Gemisch aus Isopar H, 1-Methoxy-propan-2-ol und Diethylenglykoldibutylether (65:30:5) entwickelt. Es wurde eine Druckform mit guter Auflösung erhalten.

Beispiele 9-14

Es wurde wie in Beispiel 4 gearbeitet, jedoch wurden anstelle des Polyvinylbutyrals die folgenden Bindemittel verwendet:

| Beispiel | Bindemittel |
|---|---|
| 9 | Copolymeres aus Vinylchlorid, Vinylacetat und ca. 1 % Maleinsäure (Hostaflex M 131) |
| 10 | Aromatisches, nicht reaktives lineares Polyurethan, Viskosität einer 30 %igen Lösung in Butanon 1000±500 mPa·s (Schergeschwindigkeit $D=16,3$ $s^{-1}$) bei 20° C (Desmolac 2100) |
| 11 | Kresol-Formaldehyd-Novolak, Schmelzbereich 105-120° C nach DIN 53181 |
| 12 | Hydriertes Kondensationsprodukt eines aliphatisch/aromatischen Ketons mit Formaldehyd (Kunstharz SK) |

8

| Beispiel | Bindemittel |
|---|---|
| 13 | Umsetzungsprodukt des Polyvinylbutyrals aus Beispiel 4 mit 8 % seines Gewichts an Phthalsäureanhydrid |
| 14 | Umsetzungsprodukt des Polyvinylbutyrals aus Beispiel 4 mit ca. 8 % Trimellithsäureanhydrid |

Die folgende Tabelle zeigt die Entwickelbarkeit der erhaltenen Druckplatten:

| Beispiel | a | b | c |
|---|---|---|---|
| 9 | gut | gut | gut |
| 10 | " | " | " |
| 11 | " | " | geringere Haftung |
| 12 | geringere Haftung | " | gut |
| 13 | gut | " | " |
| 14 | " | " | " |

### Beispiel 15

Es wurde wie in Beispiel 5 gearbeitet, jedoch wurde zum Entwickeln ein Gemisch von Isopar H/Isooctanol 1:1 verwendet. Es wurden Druckformen guter Auflösung erhalten.

### Beispiel 16

Es wurde wie in Beispiel 5 gearbeitet, jedoch wurde als Schichtträger das Gummituch einer Offsetdruckmaschine verwendet. Mit der erhaltenen Druckform konnte wie in den übrigen Beispielen ohne Feuchtwasser gedruckt werden.

### Beispiel 17

Es wurde wie in Beispiel 4 gearbeitet, jedoch wurde als Bindemittel anstelle des Polyvinylbutyrals die gleiche Menge des Umsetzungsprodukts aus dem in Beispiel 4 angegebenen Polyvinylbutyral und Propenylsulfonylisocyanat eingesetzt. Nach bildmäßiger Belichtung und Entwicklung mit Isopar H/Ethylacetat 1:1 wurden die belichteten Stellen abgelöst, d. h. es wurde eine negativ arbeitende Druckform für den wasserlosen Offsetdruck erhalten.

## Patentansprüche

1. Lichtempfindliche Druckplatte für den wasserlosen Offsetdruck aus einem Schichtträger, einer lichtemp-

EP 0 226 201 B1

findlichen, ein Diazoniumsalz-Polykondensationsprodukt enthaltenden Schicht und einer darüberliegenden, Druckfarbe abstoßenden vernetzten Silikonkautschukschicht, dadurch gekennzeichnet, daß das Diazoniumsalz-Polykondensationsprodukt aus wiederkehrenden Einheiten A-N$_2$X und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

2. Lichtempfindliche Druckplatte nach Anspruch 1, dadurch gekennzeichnet, daß die Einheiten A-N$_2$X sich aus Verbindungen der allgemeinen Formel

$(R^1-R^3-)_p R^2-N_2 X$

ableiten, wobei

X      das Anion der Diazoniumverbindung,
p      eine ganze Zahl von 1 bis 3,
$R^1$      einen aromatischen Rest mit mindestens einer zur Kondensation mit aktiver Carbonylverbindung befähigten Position,
$R^2$      eine Phenylengruppe,
$R^3$      eine Einfachbindung oder eine der Gruppen:

$-(CH_2)_q-NR^4-,$
$-O-(CH_2)_r-NR^4-,$
$-S-(CH_2)_r-NR^4-,$
$-S-CH_2 CO-NR^4-,$
$-O-R^5-O-,$
$-O-$
$-S-$ oder
$-CO-NR^4-$

bedeuten, worin

q      eine Zahl von 0 bis 5,
r      eine Zahl von 2 bis 5,
$R^4$      Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$      eine Arylengruppe mit 6 bis 12 C-Atomen ist.

3. Lichtempfindliche Druckplatte nach Anspruch 1, dadurch gekennzeichnet, daß die lichtempfindliche Schicht ferner ein polymeres Bindemittel enthält.

4. Lichtempfindliche Druckplatte nach Anspruch 3, dadurch gekennzeichnet, daß das Bindemittel Vinylacetaleinheiten enthält.

5. Lichtempfindliche Druckplatte nach Anspruch 3, dadurch gekennzeichnet, daß das Bindemittel ein Umsetzungsprodukt eines intramolekularen Anhydrids einer organischen Polycarbonsäure mit einem Hydroxylgruppen enthaltenden synthetischen Polymeren ist, das keine weiteren zur Umsetzung mit Säureanhydriden befähigten funktionellen Gruppen enthält.

6. Lichtempfindliche Druckplatte nach Anspruch 5, dadurch gekennzeichnet, daß die organische Polycarbonsäure eine Di- oder Tricarbonsäure ist.

7. Lichtempfindliche Druckplatte nach Anspruch 3, dadurch gekennzeichnet, daß die lichtempfindliche Schicht 5 bis 90 Gew.-% Diazoniumsalz-Polykondensationsprodukt und 10 bis 95 Gew.-% Bindemittel enthält.

10

8. Lichtempfindliche Druckplatte nach Anspruch 1, dadurch gekennzeichnet, daß der Silikonkautschuk ein Mehrkomponentenkautschuk vom Additions- oder Kondensationstyp ist.

9. Lichtempfindliche Druckplatte nach Anspruch 1, dadurch gekennzeichnet, daß die lichtempfindliche Schicht eine Schichtdicke von 0,2 bis 3 $\mu$m und die Silikonkautschukschicht eine Schichtdicke von 1 bis 20 $\mu$m hat.

**Claims**

1. A light-sensitive printing plate for waterless offset printing, composed of a layer support, of a light-sensitive layer containing a diazonium salt polycondensation product and of a superimposed ink-repellent crosslinked silicone elastomer layer, wherein the diazonium salt polycondensation product comprises recurrent $A-N_2X$ and B units which are mutually linked by bridge members, preferably methylene groups, which are derived from carbonyl compounds capable of condensation, A being the radical of an aromatic diazonium compound capable of condensation with formaldehyde and B being the radical of a compound which is free of diazonium groups and is capable of condensation with formaldehyde, in particular of an aromatic amine, a phenol, a phenol ether, an aromatic thioether, an aromatic hydrocarbon, an aromatic heterocyclic compound or an organic acid amide.

2. A light-sensitive printing plate as claimed in claim 1, wherein the $A-N_2X$ units are derived from compounds of the formula

$$(R^1-R^3-)_pR^2-N_2X$$

in which

X     is the anion of the diazonium compound,

p     is an integer from 1 to 3,

$R^1$     is an aromatic radical with at least one position capable of condensation with an active carbonyl compound,

$R^2$     is a phenylene group,

$R^3$     is a single bond or one of the groups:

$-(CH_2)_q-NR^4-$,
$-O-(CH_2)_r-NR^4-$,
$-S-(CH_2)_r-NR^4-$,
$-S-CH_2CO-NR^4-$,
$-O-R^5-O-$,
$-O-$
 $-S-$ or
$-CO-NR^4-$

in which

q     is a number from 0 to 5,

r     is a number from 2 to 5,

$R^4$     is hydrogen, an alkyl group having 1 to 5 carbon atoms, an aralkyl group having 7 to 12 carbon atoms or an aryl group having 6 to 12 carbon atoms and

$R^5$     is an arylene group having 6 to 12 carbon atoms.

3. A light-sensitive printing plate as claimed in claim 1, wherein the light-sensitive layer also contains a polymeric binder.

4. A light-sensitive printing plate as claimed in claim 3, wherein the binder contains vinyl acetal units.

5. A light-sensitive printing plate as claimed in claim 3, wherein the binder is a reaction product of an intramolecular anhydride of an organic polycarboxyl ic acid with a synthetic polymer which contains hydroxyl groups but no other functional groups capable of reacting with acid anhydrides.

6. A light-sensitive printing plate as claimed in claim 5, wherein the organic polycarboxylic acid is a dicarboxylic or tricarboxylic acid.

7. A light-sensitive printing plate as claimed in claim 3, wherein the light-sensitive layer contains 5 to 90% by weight of diazonium salt polycondensation product and 10 to 95% by weight of binder.

8. A light-sensitive printing plate as claimed in claim 1, wherein the silicone elastomer is a multi-component elastomer of the addition type or condensation type.

9. A light-sensitive printing plate as claimed in claim 1, wherein the light-sensitive layer has a thickness from 0.2 to 3 $\mu$m and the silicone elastomer layer has a thickness from 1 to 20 $\mu$m.

**Revendications**

1. Plaque d'impression photosensible pour l'impression offset à sec, constituée d'un support de couches, d'une couche photosensible contenant un produit de polycondensation de sel de diazonium, et d'une couche sus-jacente d'élastomère silicone réticulé, repoussant l'encre d'imprimerie, caractérisée en ce que le produit de polycondensation de sel de diazonium est constitué de motifs répétitifs $A-N_2X$ et B qui sont reliés les uns aux autres par des chaînons intermédiaires, de préférence des groupes méthylène, qui sont dérivés de composés carbonyle condensables, A étant le reste d'un composé diazonium aromatique condensable avec le formaldéhyde, et B étant le reste d'un composé exempt de groupes diazonium, condensable avec le formaldéhyde, en particulier d'une amine aromatique, d'un phénol, phénoléther, thioéther aromatique, d'un hydrocarbure aromatique, d'un composé hétérocyclique aromatique ou d'un amide organique.

2. Plaque d'impression photosensible selon la revendication 1, caractérisée en ce que les motifs $A-N_2X$ sont dérivés de composés de formule générale

$$(R^1-R^3)_pR^2-N_2X$$

dans laquelle
x   représente l'anion du composé diazonium,
p   est un nombre entier allant de 1 à 3,
$R^1$   représente un radical aromatique comportant au moins une position apte à la condensation avec un composé carbonyle actif,
$R^2$   représente un groupe phénylène,
$R^3$   représente une simple liaison ou l'un des groupes:

$-(CH_2)_q-NR^4-$,
$-O-(CH_2)_r-NR^4-$,
$-S-(CH_2)_r-NR^4-$,
$-S-CH_2CO-NR^4-$,
$-O-R^5-O-$,
 $-O-$,
$-S-$ ou
$-CO-NR^4-$,

dans lesquels
q   représente un nombre allant de 0 à 5,
r   représente un nombre allant de 2 à 5,
$R^4$   représente un atome d'hydrogène ou un groupe alkyle ayant de 1 à 5 atomes de carbone, un groupe aralkyle ayant de 7 à 12 atomes de carbone ou un groupe aryle ayant de 6 à 12 atomes de carbone, et
$R^5$   représente un groupe arylène ayant de 6 à 12 atomes de carbone.

3. Plaque d'impression photosensible selon la revendication 1, caractérisée en ce que la couche photosensible contient en outre un liant polymère.

4. Plaque d'impression photosensible selon la revendication 3, caractérisée en ce que le liant contient des motifs acétal de vinyle.

**5.** Plaque d'impression photosensible selon la revendication 3, caractérisée en ce que le liant contient un produit de réaction d'un anhydride intramoléculaire d'un acide polycarboxylique organique avec un polymère synthétique contenant des groupes hydroxy, qui ne contient pas d'autres groupes fonctionnels capables de réaction avec des anhydrides d'acides.

**6.** Plaque d'impression photosensible selon la revendication 5, caractérisée en ce que l'acide polycarboxylique organique est un acide di- ou tricarboxylique.

**7.** Plaque d'impression photosensible selon la revendication 3, caractérisée en ce que la couche photosensible contient de 5 à 90 % en poids de produit de polycondensation de sel de diazonium et de 10 à 95 % en poids de liant.

**8.** Plaque d'impression photosensible selon la revendication 1, caractérisée en ce que l'élastomère silicone est un élastomère à plusieurs composants du type obtenu par addition ou par condensation.

**9.** Plaque d'impression photosensible selon la revendication 1, caractérisée en ce que la couche photosensible a une épaisseur de couche de 0,2 à 3 $\mu$m et la couche d'élastomère silicone a une épaisseur de couche de 1 à 20 $\mu$m.